# EUROPÄISCHE PATENTSCHRIFT

(11) **EP 0 759 660 B1**
(45) Veröffentlichungstag und Bekanntmachung des Hinweises auf die Patenterteilung: **17.10.2001**
(21) Anmeldenummer: 96112315.5
(22) Anmeldetag: 30.07.1996
(51) Int. Cl.: H03K 17/96

(54) **Eingabevorrichtung für einen Messumformer**
Data input device for a measuring transformer
Dispositif d'entrée de données pour un transducteur de mesure

(30) Priorität: 10.08.1995 DE 29512899 U
(43) Veröffentlichungstag der Anmeldung: 26.02.1997
(73) Patentinhaber: SIEMENS AKTIENGESELLSCHAFT, 80333 München (DE)
(72) Erfinder: Förnsel, Helmut, 76887 Bad Bergzabern (DE); Grassel, Friedrich, 68753 Waghäusel (DE)

(56) Entgegenhaltungen:
- EP-A- 0 618 680
- WO-A-84/03186
- WO-A-85/04295
- CH-A- 676 177

## Beschreibung

Die Erfindung betrifft eine Eingabevorrichtung für einen Meßumformer nach dem Oberbegriff des Anspruchs 1.

Aus der EP-OS 0 618 680 ist eine Eingabevorrichtung für einen Meßumformer bekannt, die eine optoelektronische, fingerbetätigte Tastatur mit mehreren Tasten aufweist. Die Tasten haben eine für Infrarotlicht durchlässige Abdeckung, jeweils einen an der Innenseite der Abdeckung angeordneten und dagegen praktisch senkrecht und eng gebündelt strahlenden Infrarotlichtsender und einen daneben und vom Lichtsender durch eine für Infrarotlicht undurchlässige Abschirmung getrennt angeordneten, zur Abdeckung und zum Tastenfeld hin ausgerichteten Infrarotlichtempfänger. Der Lichtempfänger liegt innerhalb des Hauptstrahlungsbereichs des von einem Lichtsender ausgestrahlten und beispielsweise an einem Finger über dem Eingabefeld einer Taste gestreuten Infrarotlichts. Er ist jedoch außerhalb des von der Außenseite oder der Innenseite der Abdeckung reflektierten Lichts angeordnet. Für jede Taste ist eine eigene Steuer- und Detektionsschaltung vorhanden.

Aus der WO 85/04295 ist eine optoelektronische Tastatur bekannt, die eine lichtdurchlässige Platte mit Tasten aufweist, die an der Plattenoberseite als Eingabefelder markiert sind. Auf der den Eingabefeldern gegenüberliegenden Plattenunterseite sind lichtemittierende Dioden angeordnet, die von unten her das jeweilige Eingabefeld beleuchten. An der Kante der lichtdurchlässigen Platte befindet sich ein Lichtempfänger, der von dieser durch einen Luftspalt getrennt ist. Die Sendedioden werden zeitmultiplex betrieben, d. h. zu jedem Zeitpunkt wird nur ein Eingabefeld durch eine Sendediode beleuchtet. Durch entsprechendes Demultiplexen des Empfangssignals, das der seitlich angeordnete Lichtempfänger liefert,
wird bestimmt, ob eine Taste aktiviert ist. Solange die Eingabefelder nicht berührt werden, tritt aufgrund der Totalreflexion innerhalb der Glasplatte nur wenig Licht an der Kante aus und gelangt zum Empfänger. Wird zur Tastenbedienung ein Gegenstand oder eine Fingerspitze auf das Eingabefeld aufgesetzt, so wird das Licht der jeweils zugeordneten lichtemittierenden Diode an der Berührungsfläche diffus gestreut. Dies wirkt sich als Änderung der Lichtintensität beim Empfänger aus. Zur Tastenbetätigung muß also die Oberfläche der Platte im Bereich des Eingabefeldes berührt werden.

Der Erfindung liegt die Aufgabe zugrunde, eine Eingabevorrichtung für einen Meßumformer zu schaffen, die bei geringerem Aufwand ein gutes Nutz-/Störsignalverhältnis und eine sichere Funktion auch bei einer größeren Dicke der Abdeckung gewährleistet.

Zur Lösung dieser Aufgabe weist die neue Eingabevorrichtung der eingangs genannten Art die im kennzeichnenden Teil des Anspruchs 1 angegebenen Merkmale auf. In den Unteransprüchen sind vorteilhafte Weiterbildungen der Erfindung beschrieben.

Die Erfindung hat den Vorteil, daß das Nutz-/Störsignalverhältnis weitgehend unabhängig von der Dicke der Abdeckung ist. Dadurch kann die Eingabevorrichtung sowohl bei Meßumformern mit leichtem Aufbau als auch bei Meßumformern für den eigensicheren Bereich mit einer Glasscheibe, deren Dicke 10 mm und mehr beträgt, eingesetzt werden. Ebenso ist der Stromverbrauch der Eingabevorrichtung ausreichend gering, so daß im eigensicheren Bereich die Eingabevorrichtung den Energiebedarf des Meßumformers nicht ungebührlich erhöht und der Meßumformer über dieselbe Leitung, über die auch die Meßwerte zu einer zentralen Auswertestelle übertragen werden, mit einer Betriebsspannung versorgt werden kann. Durch die flache Lage des Empfangskegels, der nahezu parallel zur Ober- und Unterseite der Abdeckung ausgerichtet ist, wird erreicht, daß die Tasten lediglich im Nahbereich empfindlich sind und nur schalten, wenn sich ein Objekt unmittelbar über den Eingabefeldern befindet. Da vorwiegend die Größe der Sendekegel die räumlichen Abmessungen der Eingabefelder der Tasten bestimmt, ist mit der erfindungsgemäßen Eingabevorrichtung eine bessere Trennung der räumlichen Empfindlichkeitsbereiche und damit ein präziseres Einhalten der Grenzen der Eingabefelder auch bei größerer Dicke der Abdeckung zu erreichen. Ursache dafür sind im wesentlichen der Multiplexbetrieb der Sender und der nahezu parallele Strahlengang des zu den Eingabefeldern gesendeten Lichts.

Anhand der Zeichnungen, in denen Ausführungsbeispiele der Erfindung dargestellt sind, werden im folgenden Ausgestaltungen sowie Vorteile der Erfindung näher erläutert.

Es zeigen:
- Figur 1: eine Prinzipdarstellung einer erfindungsgemäßen Eingabevorrichtung,
- Figur 2: ein Bedienfeld eines Meßumformers mit einer erfindungsgemäßen Eingabevorrichtung,
- Figur 3: ein Blockschaltbild einer geeigneten Ansteuer- und Auswerteschaltung und
- Figur 4: ein Zeitdiagramm der wesentlichen Signale des Blockschaltbilds nach Figur 3.

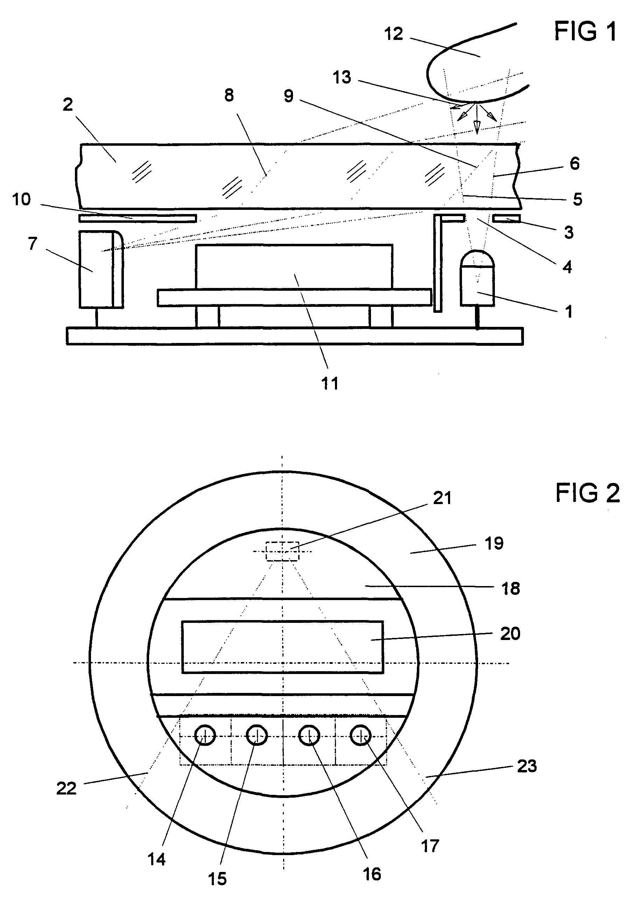

Gemäß Figur 1 ist eine Infrarotsendediode 1 unterhalb einer Abdeckung 2, die für das Infrarotlicht durchlässig ist, derart angeordnet, daß sie etwa senkrecht auf die Unterseite der Abdeckung 2 strahlt. Durch eine Blende 3 wird im Bereich der Blendenöffnung 4 Licht hindurchgelassen, so daß durch den Sender 1 lediglich ein Eingabefeld auf der Oberseite der Abdeckung 2 bestrahlt wird. Auf diese Weise wird ein relativ kleiner Öffnungswinkel des Sendekegels, der in Figur 1 durch Begrenzungslinien 5 und 6 markiert ist, erreicht, so daß die auf der Oberseite der Abdeckung 2 bestrahlte Fläche nahezu unabhängig von der Dicke der Abdeckung 2 ist. Zur Verbesserung des Nutz-/Störsignalverhältnisses wird gepulstes Licht verwendet. Senkrecht zur Zeichnungsebene sind drei weitere Sendedioden hintereinander, die in dieser Darstellung nicht sichtbar sind, für weitere Tasten angeordnet. In einiger Entfernung neben dem Sender 1 befindet sich ein Empfänger 7, der auf die Wellenlänge und die Pulsfrequenz des gesendeten Lichts abgestimmt ist. Sein Empfangskegel, der durch Linien 8 und 9 begrenzt wird, verläuft nahezu parallel unterhalb der Abdeckung 2 entlang und ist durch eine Blende 10 und ein Gehäuse 11 einer Anzeigeeinheit, die zusammen wie eine Schlitzblende wirken, derart eingestellt, daß alle Eingabefelder eingeschlossen werden. Durch die relativ große Entfernung zwischen dem Sender 1 und dem Empfänger 7 wird eine Führung des Empfangskegels in relativ flachem Winkel durch die Abdeckung 2 hindurch möglich. Dies bewirkt, daß die Tasten nur im Nahbereich über den Eingabefeldern schalten. Eine Bereichseinstellung ist durch die Lage der Blende 10 leicht möglich, die gleichzeitig als Fremdlichtschutz wirkt. Zur Verdeutlichung des Funktionsprinzips der Eingabevorrichtung ist oberhalb des Eingabefeldes ein Finger 12 angedeutet, an dessen Unterseite das Licht des Senders 1 diffus reflektiert wird. Da sich der Finger 12 innerhalb des Nahbereichs über dem Eingabefeld befindet, gelangt ein Lichtstrahl 13 innerhalb des Empfangskegels zum Empfänger 7, und eine Aktivierung der Taste wird erkannt. In Figur 1 wird besonders deutlich, daß sich die Dicke der Abdeckung 2 in einem weiten Bereich bewegen kann, ohne die Empfindlichkeit, die Lage und die Größe der Eingabefelder wesentlich zu beeinflussen.

In der Draufsicht nach Figur 2 ist ein Bedienfeld mit vier Tasten dargestellt. Die Lage der Tasten wird durch Blendenöffnungen 14 ... 17 von Infrarotlichtsendern bestimmt. Diese sind unter einer Glasscheibe 18 angeordnet, die von einem Stahlring 19 eines Meßumformers getragen wird. Oberhalb der vier Tasten befindet sich ein Anzeigefeld 20 zur Informationsausgabe. Mit diesem Bedienfeld kann eine menügeführte Parametrierung eines Meßumformers, der druckfest gekapselt ist, vorgenommen werden. Ein Empfänger 21, der mit durchbrochenen Linien in Figur 2 dargestellt und in der Draufsicht durch eine Blende verdeckt ist, dient zum Empfang des im Bereich der Tasteneingabefelder oberhalb der Glasplatte 18 diffus reflektierten Lichts. Mit punktierten Linien 22 und 23 sind die Ränder seines Empfangskegels markiert, der die Eingabefelder aller Tasten überstreicht.

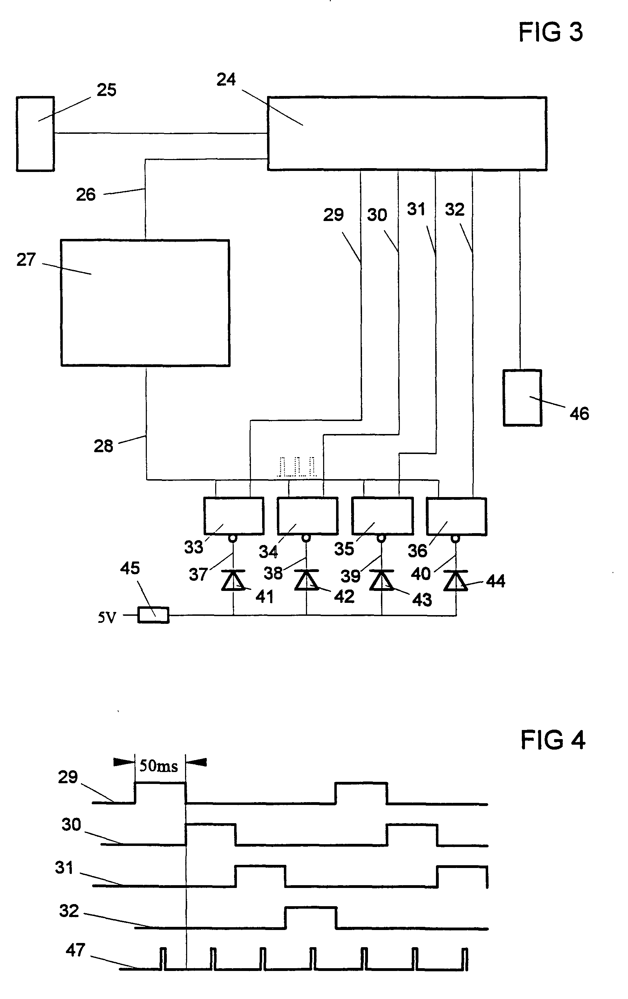

Gemäß Figur 3 wird in einer Ansteuer- und Auswerteschaltung als zentrales Element ein Mikroprozessor 24 mit einem Betriebsprogramm verwendet, der außer seinen Funktionen im Zusammenhang mit der Eingabevorrichtung auch weitere Aufgaben des Meßumformers, z. B. die Meßwertaufbereitung und -übertragung zu einem Automatisierungsgerät, übernimmt. Seinen Arbeitstakt erhält der Prozessor 24 von einem Oszillator 25. Daraus leitet er ein 4-MHz-Taktsignal 26 ab, das auf eine Pulsformerschaltung 27 geführt ist. Die Pulsformerschaltung 27 bildet einen Puls 28 der Frequenz von etwa 38 kHz und mit relativ kleinem Puls-Pausen-Verhältnis. Weiterhin erzeugt der Prozessor 24 vier Steuersignale 29 ... 32, die jeweils zusammen mit dem Puls 28 auf NAND-Gatter 33 ... 36 geführt sind. Die Ausgangssignale 37 ... 40 der NAND-Gatter 33 ... 36 sind jeweils low-aktiv und ziehen den zum Betreiben der Sendedioden 41 ... 44 erforderlichen Strom aus einem Pull-up-Widerstand 45, der mit seinem anderen Ende auf 5 V gelegt ist. Somit senden die Sendedioden 41 ... 44 jeweils gerade dann ein gepulstes Licht der Frequenz von etwa 38 kHz, wenn ihr zugehöriges Steuersignal 29 ... 32 durch den Prozessor 24 aktiv geschaltet ist. Es können beispielsweise Dioden des Typs SFH415-T der Firma Siemens eingesetzt werden. Darauf abgestimmt wird ein Empfänger 46 des Typs SFH506-38 der Firma Siemens verwendet, der an einen Eingang des Prozessors 24 angeschlossen ist. Er enthält einen Bandpaßfilter, der auf eine Empfangsfrequenz von 38 kHz eingestellt ist.

Anhand des Zeitdiagramms in Figur 4 wird im folgenden das in der erfindungsgemäßen Eingabevorrichtung verwendete Zeitmultiplexverfahren näher erläutert. Der in Figur 3 gezeigte Prozessor 24 aktiviert zunächst das Steuersignal 29 für die Sendediode 41 für einen Zeitraum von 50 ms. Dazu wird eine entsprechende Einstellung an einem Ausgabe-Port des Prozessors 24 durch das Betriebsprogramm vorgenommen. Einige Millisekunden später wird der Signalpegel am Eingang des Prozessors 24, an dem der Empfänger 46 angeschlossen ist, abgefragt. Diese Abfragezeitpunkte sind in Figur 4 durch Impulse eines Signalverlaufs 47 verdeutlicht. Das Betriebsprogramm kann aus dem Abfrageergebnis zum Zeitpunkt des ersten auftretenden Impulses feststellen, ob die der Sendediode 41 zugeordnete Taste bedient wurde. Daraufhin wird mit einem Impuls von ebenfalls 50 ms Dauer auf dem Steuersignal 30 die Sendediode 42 aktiviert und wiederum der Empfänger 46 abgefragt, um eine Aktivierung der zugehörigen Taste zu ermitteln, wie es bereits für die Sendediode 41 beschrieben wurde. In entsprechender Weise werden in einem Abfragezyklus auch Bedienungen der den Sendedioden 43 und 44 zugeordneten Tasten ermittelt. Der beschriebene Ablauf wird zyklisch wiederholt. Das von den Sendedioden 41 ... 44 insgesamt ausgesendete Licht ist somit zeitlich gemultiplext, durch die Wahl der Abfragezeitpunkte stellt die Auswertung des Empfangssignals ein zeitliches Demultiplexen dar. Dabei wirkt es sich auf den Stromverbrauch der Eingabevorrichtung besonders günstig aus, daß die Sendedioden 41 ... 44 im Pulsbetrieb mit geringem Tastverhältnis arbeiten und darüber hinaus immer nur eine Sendediode aktiviert ist. Da im wesentlichen die ohnehin in einem Meßumformer vorhandenen Schaltungsteile für die Eingabevorrichtung verwendet werden können, sind die zusätzlich erforderlichen Bauteilkosten gering. Insbesondere die Zahl der Empfängerbausteine ist gegenüber bekannten Verfahren erheblich reduziert.

In diesem Ausführungsbeispiel wurde das Zeitmultiplexverfahren beschrieben. Selbstverständlich sind auch andere Multiplexverfahren anwendbar.

## Patentansprüche

1. Eingabevorrichtung für einen Meßumformer
- mit einer im wesentlichen ebenen Platte als Abdeckung (2, 18), die für elektromagnetische Strahlung zumindest einer Wellenlänge, insbesondere Infrarotlicht, durchlässig ist,
- mit zumindest zwei Tasten, denen jeweils ein Oberflächenbereich der Abdeckung (2, 18) als Eingabefeld zugeordnet ist,
- mit einem Sender (1, 41 ... 44) für jede Taste, der eine elektromagnetische Strahlung von der Unterseite her gegen das jeweilige Eingabefeld richtet,
- mit einem für mehrere Tasten gemeinsamen Empfänger (7, 21, 46), der ein Empfangssignal erzeugt,
- wobei die Sender (1, 41 ... 44) im Multiplexbetrieb arbeiten und durch entsprechendes Demultiplexen des Empfangssignals die aktivierte Taste bestimmt wird,
**dadurch gekennzeichnet,**
- **daß** der Empfänger (7, 21, 46) unterhalb der Platte (2, 18) seitlich versetzt zu den Sendern angeordnet ist und sein Empfangskegel unterhalb der Platte (2, 18) nahezu parallel zu dieser mit zur Plattenunterseite hin kleinem Öffnungswinkel verläuft, jedoch parallel zur Plattenunterseite so weit geöffnet ist, daß die Eingabefelder eingeschlossen werden, so daß der Empfänger (7, 21, 46) nur dann die elektromagnetische Strahlung eines Senders (1, 41 ... 44) empfängt, wenn sich vor dem jeweiligen Eingabefeld ein reflektierendes Objekt (12) zur Tastenaktivierung befindet.

2. Eingabevorrichtung nach Anspruch 1, **dadurch gekennzeichnet**,
- **daß** die Sender (1, 41 ... 44) jeweils in einem Sendekegel etwa senkrecht durch die Platte (2, 18) hindurch zum jeweiligen Eingabefeld strahlen und
- **daß** Sende- und Empfangskegel jeweils durch Blenden (3, 10, 11) begrenzt sind.

3. Eingabevorrichtung nach Anspruch 1 oder 2, **dadurch gekennzeichnet**,
- **daß** die Sender (1, 41 ... 44) in der Abdeckung (2, 18) eine nahezu parallele Strahlung von der Unterseite her zum jeweiligen Eingabefeld erzeugen.

4. Eingabevorrichtung nach einem der vorhergehenden Ansprüche, **dadurch gekennzeichnet**,
- **daß** die Sender (1, 41 ... 44) im Zeitmultiplexbetrieb arbeiten, so daß jeweils nur ein Sender aktiv ist.

5. Eingabevorrichtung nach einem der vorhergehenden Ansprüche, **dadurch gekennzeichnet**,
- **daß** die Ansteuerung der Sender und die Auswertung des Empfangssignals zur Erkennung einer Eingabe im wesentlichen durch denselben Prozessor (24) erfolgt, der im Meßumformer auch weitere Aufgaben, z. B. Meßwertaufbereitung und -übertragung, ausführt.

6. Eingabevorrichtung nach einem der vorhergehenden Ansprüche, **dadurch gekennzeichnet**,
- **daß** vier Tasten vorhanden sind.

## Claims

1. Input device for a measuring transducer
- having a substantially planar plate as a cover (2, 18), which is permeable to electromagnetic radiation of at least one wavelength, in particular infrared light,
- having at least two keys, with which is associated a respective surface region of the cover (2, 18) as an input field,
- having a transmitter (1, 41 ... 44) for each key, which transmitter directs electromagnetic radiation from the underside towards the respective input field,
- having a receiver (7, 21, 46), which is common to a plurality of keys and which generates a received signal,
- wherein the transmitters (1, 41 ... 44) work in multiplex operation, and the activated key is determined as a result of corresponding demultiplexing of the received signal,
**characterised in that**
- the receiver (7, 21, 46) is arranged underneath the plate (2, 18) laterally offset with respect to the transmitters and its reception cone extends underneath the plate (2, 18) substantially parallel to the latter with a small aperture angle with respect to the underside of the plate, but is opened parallel to the underside of the plate so far that the input fields are included, so that the receiver (7, 21, 46) receives the electromagnetic radiation of a transmitter (1, 41 ... 44) only if a reflecting item (12) for activation of a key is located in front of the respective input field.

2. Input device according to claim 1, **characterised**
- **in that** the transmitters (1, 41 ... 44) each radiate in a transmission cone substantially perpendicularly through the plate (2, 18) towards the respective input field, and
- **in that** the transmission and reception cones are each delimited by diaphragms (3, 10, 11).

3. Input device according to claim 1 or 2, **characterised**
- **in that** the transmitters (1, 41 ... 44) generate in the cover (2, 18) an almost parallel beam from the underside towards the respective input field.

4. Input device according to one of the preceding claims, **characterised**
- **in that** the transmitters (1, 41 ... 44) work in time-division multiplex operation, so that only one transmitter is active in each case.

5. Input device according to one of the preceding claims, **characterised**
- **in that** the triggering of the transmitters and the evaluating of the received signal for recognising an input are carried out basically by the same processor (24) which, in the measuring transducer, also executes further tasks, for example measured-value conditioning and measured-value transmission.

6. Input device according to one of the preceding claims, **characterised**
- **in that** there are four keys.

## Revendications

1. Dispositif d'entrée pour un transducteur de mesure, comportant
- une plaque sensiblement plane comme couverture (2, 18) qui est transparente au rayonnement électromagnétique d'au moins une longueur d'onde, en particulier à la lumière infrarouge,
- au moins deux touches auxquelles est associée à respectivement une zone de surface de la plaque de couverture (2, 18) comme champ d'entrée,
- un émetteur (1, 41 à 44) pour chaque touche, lequel dirige un rayonnement électromagnétique par en dessous vers le champ d'entrée respectif,
- un récepteur (7, 21, 46) qui est commun à plusieurs touches et qui produit un signal de réception,
- les émetteurs (1, 41 à 44) travaillant en fonctionnement multiplex et la touche activée étant déterminée par un démultiplexage correspondant du signal de réception,
**caractérisé par le fait que**
- le récepteur (7, 21, 46) est disposé en dessous de la plaque (2, 18) et décalé sur le côté par rapport aux émetteurs et son cône de réception s'étend en dessous de la plaque (2, 18) presque parallèlement à celle-ci avec un angle d'ouverture petit vers le dessous de la plaque mais est ouvert si largement parallèlement au dessous de la plaque que les champs d'entrée sont inclus de telle sorte que le récepteur (7, 21, 46) ne reçoit le rayonnement électromagnétique d'un émetteur (1, 41 à 44) que lorsqu'un objet réfléchissant (12) destiné à l'activation d'une touche se trouve devant le champ d'entrée respectif.

2. Dispositif d'entrée selon la revendication 1, **caractérisé par le fait que**
- les émetteurs (1, 41 à 44) émettent à chaque fois dans un cône d'émission sensiblement perpendiculairement à travers la plaque (2, 18) vers le champ d'entrée respectif, et
- les cônes d'émission et de réception sont limités respectivement par des diaphragmes (3, 10, 11).

3. Dispositif d'entrée selon la revendication 1 ou 2, **caractérisé par le fait que**
- les émetteurs (1, 41 à 44) produisent dans la plaque de couverture (2, 18) un rayonnement presque parallèle par en dessous vers le champ d'entrée respectif.

4. Dispositif d'entrée selon l'une des revendications précédentes, **caractérisé par le fait que**
- les émetteurs (1, 41 à 44) travaillent en fonctionnement à multiplexage temporel de telle sorte qu'un seul émetteur est actif à chaque fois.

5. Dispositif d'entrée selon l'une des revendications précédentes, **caractérisé par le fait que**
- le contrôle des émetteurs et l'évaluation du signal de réception pour la détection d'une entrée sont effectués sensiblement par le même processeur (24) qui met aussi en oeuvre d'autres tâches dans le transducteur de mesure, par exemple la préparation et la transmission de valeurs mesurées.

6. Dispositif d'entrée selon l'une des revendications précédentes, **caractérisé par le fait qu'**il y a quatre touches.
